Europäisches Patentamt

European Patent Office

Office européen des brevets

(11) Numéro de publication: **0 449 201 A1**

# (12) DEMANDE DE BREVET EUROPEEN

(21) Numéro de dépôt: **91104757.9**

(22) Date de dépôt: **26.03.91**

(51) Int. Cl.5: **H03M 13/12, H04L 1/00**

(30) Priorité: **30.03.90 FR 9004090**

(43) Date de publication de la demande:
**02.10.91 Bulletin 91/40**

(84) Etats contractants désignés:
**DE ES FR GB IT NL SE**

(71) Demandeur: **ALCATEL TRANSMISSION PAR FAISCEAUX HERTZIENS A.T.F.H.**
**55, rue Greffulhe**
**F-92301 Levallois-Perret Cédex(FR)**

(72) Inventeur: **Darmon, Marc**

**21, rue Barbet de Jouy**
**F-75007 Paris(FR)**
Inventeur: **Bazet, André**
**37, rue Georges Boisseau**
**F-92110 Clichy(FR)**
Inventeur: **Brelivet, Pascal**
**212, rue de Tolbiac**
**F-75013 Paris(FR)** ·

(74) Mandataire: **Weinmiller, Jürgen et al**
**Lennéstrasse 9 Postfach 24**
**W-8133 Feldafing(DE)**

(54) **Procédé et dispositif de décodage séquentiel d'un train numérique codé par un code correcteur d'erreurs de type convolutif.**

(57) Procédé et dispositif de décodage séquentiel utilisant l'algorithme de pile.

On utilise une pile (2) qui est percée en son fond (3) et qui est de dimentions réduites. Un compteur (4) mémorise le nombre total de noeuds observés, afin de renoncer au décodage si ce nombre dépasse une valeur fixée. Un comparateur (32) compare sans arrêt la plus grande métrique perdue en fond de pile et mise dans une mémoire (9), à la métrique en haut de pile. Une petite mémoire (7) mémorise le chemin exploré dans l'arbre logique,et fournit ainsi directement le bloc décodé.

FIG 1

La présente invention se rapporte à un procédé et à un dispositif de décodage séquentiel d'un train numérique codé par un code correcteur d' erreurs de type convolutif.

Les transmissions numériques, en particulier les transmissions par faisceau hertzien, sont fréquemment soumises à des brouillages, la plupart du temps involontaires, qui introduisent des erreurs dans le train reçu. Il est donc pratiquement indispensable de coder le train à émettre au moyen d'un code correcteur d'erreurs, et de décoder le train reçu au moyen d'un décodeur correcteur d'erreurs, afin de récupérer l'information malgré les brouillages.

Les codes correcteurs d'erreurs actuellement les plus répandus sont les codes en blocs et les codes convolutifs.

Les codes en blocs, qui sont les plus simples, consistent à ajouter à chaque bloc de bits à émettre un nombre déterminé de bits de redondance. Ces codes sont peu performants et ne peuvent donc pas être utilisés pour des messages risquant d' être très brouillés.

Les codes convolutifs, qui aboutissent à faire correspondre à un train initial à émettre un train effectivement émis dont le nombre de bits est multiplié par un facteur n donné, par exemple un facteur 2 ou un facteur 3, chaque groupe de n bits ainsi créé pour chaque bit initial dépendant des groupes précédents, sont bien plus complexes, mais en revanche bien plus performants;

Deux solutions sont généralement utilisées pour réaliser le décodage correcteur d'erreurs de trains numériques codés par un code convolutif :

. Une première solution est d'utiliser l'algorithme de VITERBI, qui consiste à examiner tous les cas possible sur un très grand nombre, et à choisir le cas le plus probable. Cet algorithme est optimal, mais il est complexe à réaliser.

. Une seconde solution est d'utiliser un "décodage séquentiel", qui est moins optimal mais qui est, en revanche, plus rapide et plus simple à réaliser, surtout pour les codes compliqués. L'algorithme séquentiel n' est pas de complexité croissante avec la performance du code, et il permet donc de décoder des codes très performants.

En matière de décodage séquentiel, deux algorithmes et leurs variantes sont généralement utilisés pour effectuer un décodage séquentiel : l'algorithme de FANO, maintenant un peu démodé, et l'algorithme de pile.

Selon l'algorithme de pile, le décodage s'effectue par blocs (par exemple par blocs de 1000 bits), et il consiste à réaliser un "parcours" dans un "arbre logique" binaire symbolisant le décodage, chaque noeud de l'arbre étant défini par une "profondeur" représentative de sa distance par rapport au noeud initial de l'arbre, et possédant, pour le train de bits considéré, une probabilité définie par une valeur numérique appelée "métrique". Les noeuds observés sont alors rangés dans une pile ordonnée, le noeud de plus grandemétrique étant prolongé à chaque fois par ses deux successeurs.

Plus précisément, pour chaque groupe de bits codés reçus et correspondant à un bit, avant codage, du train émis :

. on enlève le noeud se trouvant en haut de la pile,

. on calcule alors les métriques des deux noeuds successifs à ce noeud,

. on les introduit dans la pile,

. on classe finalement la pile par noeuds de métriques décroissantes.

Lorsque la taille limite de la pile est dépassée (la pile déborde), le bloc est déclaré mal reçu et non décodé ; on peut alors demander une retransmission de ce bloc ou le considérer perdu. Typiquement la taille maximum de la pile est comprise entre une fois et dix fois le nombre de bits dans un bloc à décoder. En fait plus la pile est petite, plus un nombre important de blocs ne seront par décodés (la pile débordera souvent), et si la pipe est plus grande, un nombre plus grand de blocs sera décodé avec le risque de décoder des blocs très mal reçus et donc avec des erreurs.

Les inconvénients principaux de ce dernier décodage sont qu' il nécessite une grande pile (la profondeur est typiquement entre une et dix fois la taille des blocs à décoder : donc de 1000 à 10.000 si on décode des blocs de 1000 bits), que cette pile est lente à classer par ordre croissant des métriques des noeuds (alors qu' il faut faire ce classement à chaque exploration d'un nouveau noeud, donc entre une fois et dix fois par bit décodé), et qu'à la fin du décodage d'un bloc, il faut revenir en arrière pour savoir quel a été le bloc réellement émis (c'est ce que l'on appelle le "Trace-back"). Tous ces inconvénients font qu'il est très difficile de réaliser concrètement un tel décodeur du fait de son encombrement et du nombre important de traitements par bit décodé qui limite sa vitesse. Sur les réalisations existantes. La pile est réalisée au moyen d'une Mémoire RAM (mémoire vive) qui est classée à chaque exploration du noeud.

L'invention, qui vise à remédier à ces inconvénients, se propose de permettre d'implémenter un tel décodeur séquentiel à moindre coût d'encombrement, de composants, et pouvant fonctionner à haut débit. Elle se rapporte à cet effet à un procédé et à un dispositif de décodage séquentiel d'un train numérique codé par un code correcteur d'erreurs de type convolutif, ce décodage séquentiel utilisant l'algorithme de pile, et ce procédé consistant à utiliser une pile percée en son fond (perdant de ce fait les noeuds de plus basse métrique à mesure que d'autres noeuds, conformément à l'algorithme de pile, entrent par le haut de la pile) et avantageusement très petite, la taille de cette pile pouvant être par exemple inférieure à 100 cellules quelle que soit la taille des blocs, tout en mémorisant le nombre total de noeuds observés, conformément à l'algorithme de pile, lors du décodage d'un bloc: le dépassement par ce nombre d'une valeur limite fixée à l'avance, comprise typiquement entre une et dix fois la taille d'un bloc, constitue alors l'indication du renoncement au décodage de ce bloc.

De toute façon, l'invention sera bien comprise, et ses avantages et autres caractéristiques ressortiront, lors de la description suivante d'un exemple non limitatif de réalisation, en référence au dessin schématique annexé dans lequel :

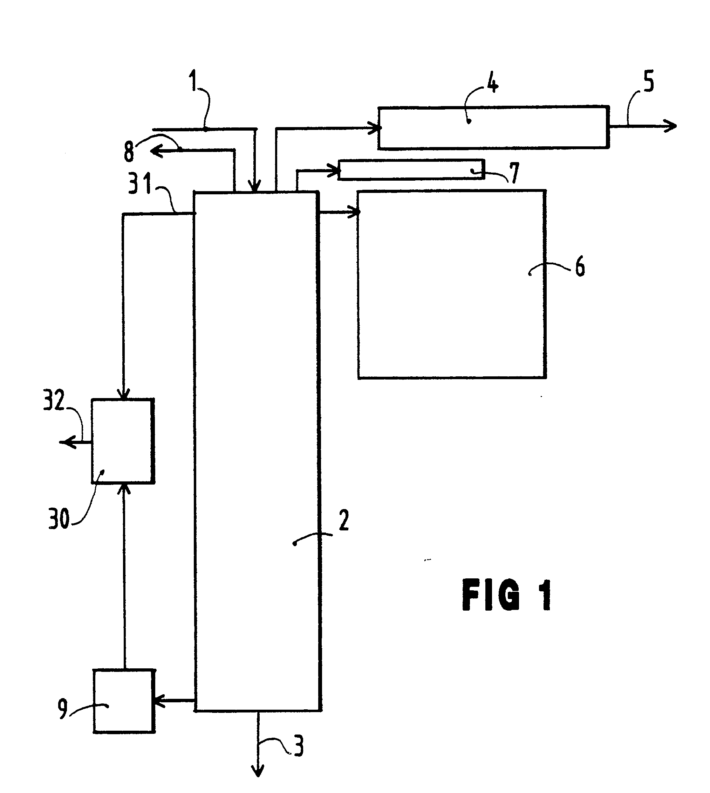

. Figure 1 est un schéma explicatif du fonctionnement de ce dispositif de décodage ;

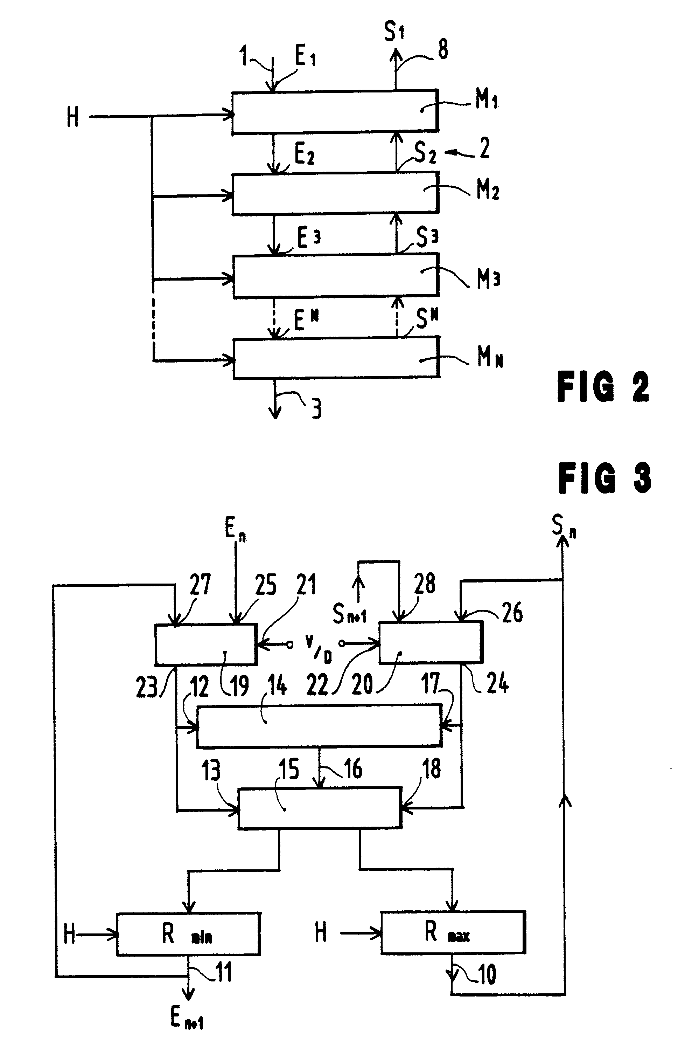

. Figure 2 est un synoptique d'ensemble de la pile percée qui est utilisée dans ce dispositif; et

. Figure 3 représente plus en détails une des cellules de la pile de la figure 2.

En se référant à la figure 1, le train numérique reçu 1, qui est codé par un code convolutif, est appliqué, selon le principe général du décodage séquentiel par l'algorithme de pile, à une pile 2 qui, conformément à l'invention est d'une part "percée" en son fond , c'est à dire qu' elle perd en 3 les "noeuds" de plus basse métrique au fur et à mesure que d'autres "noeuds" entrent par le haut de la pile en 1, et est d'autre part avantageusement de très petite taille, cette taille étant totalement indépendante de la taille des blocs à décoder. Typiquement, la taille de cette pile 2 peut être inférieure à 100 cellules : par exemple, cette pile est composée de 40 cellules.

Le nombre total de noeuds observés conformément à l'algorithme de pile est, pour un bloc donné, mémorisé dans un compteur 4 dont l'indication, en 5, du dépassement d'un nombre limite fixé à l'avance, et typiquement compris entre 1 et 10 fois la taille d'un bloc, est le signal de décision de renoncement au décodage du bloc considéré.

Du fait que seuls les noeuds de plus basse métrique (la pile 2 étant, à chaque fois, classée conformément à l'algorithme de pile, chaque noeud exploré étant classiquement évacué en 8), sont écartés en 3, les performances d'un tel dispositif sont équivalentes à celles d'un dispositif classique conservant tous les noeuds observés et qui nécessiterait une pile constituée, avec une taille de blocs reçus de 1000 bits par exemple, d'une série de 1000 à 10000 cellules.

De manière classique, l'ensemble des noeuds explorés et mis dans la pile 2 est mémorisé dans une mémoire 6, avec les profondeurs de ces noeuds dans l'arbre logique et les transitions (0 ou +1) qui leur correspondent. Selon une caractéristique avantageuse de l'invention, il est considéré que les noeuds d'ordre pair correspondent par exemple à une transition 0 et que les noeuds d'ordre impair correspondent par exemple à une transition +1 : de la sorte, il n'est pas utile de mémoriser la transition correspondant à chaque noeud, puisque cette transition est le "LSB" (bit de plus faible poids binaire) du numéro binaire du noeud.

Par ailleurs, selon une autre caractéristique avantageuse de l'invention, une autre mémoire 7, très petite (par exemple d'une contenance de l'ordre d'un millier de bits pour des blocs de 1000 bits environ) est utilisée pour mémoriser le chemin exploré de l'arbre. Ainsi, lorsque le décodage est terminé, c'est à dire lorsqu'un noeud situé au bout de l'arbre logique vient d'être exploré, le chemin exploré (c'est à dire le bloc décodé) est directement inscrit dans la mémoire 7, et il n'est donc pas nécessaire d'effectuer l'exploration classique de retour en arrière le long de l'arbre logique, ou "traceback".

Afin d'éviter le risque, extrêmement faible d'ailleurs de perdre en 3 un noeud conduisant au chemin optimal, l'invention propose avantageusement par ailleurs de mémoriser, dans une mémoire 9, la métrique maximale des noeuds écartés en 3, et, au moyen d'un comparateur 30, de vérifier à chaque fois que cette métrique n'est pas supérieure à la métrique, extraite en 31, du noeud en haut de pile qui va, selon l'algorithme de pile, être prolongé par ses deux successeurs. Si cette plus grande métrique des noeuds écartés en 3 est tout à coup supérieure à la métrique (en 31) du haut de pile, cela signifie que l'on a vraisemblablement perdu le chemin optimal, et le signal qui sort alors en 32 du comparateur 30 est alors, à l'instar du signal en 5, un signal représentatif d'un décodage échoué. (Ceci augmente très légèrement le nombre de blocs dont le décodage échoue, cette augmentation étant en fait trop faible pour être significative (elle se situe par exemple dans un rapport inférieur à $10^{-4}$ % si l'on conserve plus de 40 cellules).

La pile percée 2 peut bien entendu être classiquement réalisée par utilisation d'une mémoire vive. Cependant, une forme avantageuse de l'invention consiste à utiliser, pour réaliser cette pile percée avec ses fonctions de classement et d'éjection en 8 du contenu de la cellule du haut, le nouveau dispositif de stockage et de classement de données numériques qui sera maintenant décrit en référence aux figures 2 et 3.

En se reportant à la figure 2, ce dispositif 2 se compose d'une série descendante de modules ou cellules identiques M1, M2, M3,..., MN qui sont branchés en cascade et qui sont synchronisés par une horloge commune H. Il s'agit donc d'une pile "systolique", c'est à dire d'une pile faite d'une série de modules identiques et travaillant tous en même temps.

Chaque module de la pile comporte une entrée E1, E2, E3,...EN, de données provenant d'une manière générale d'un registre du module précédent. Bien entendu, l'entrée E1 du module supérieur M1 de la pile constitue l'entrée 1 des données nouvelles introduites dans cette pile.

Par ailleurs, chaque module de cette pile possède un registre de sortie, dont les données SN,..., S3, S2 sont appliquées au module supérieur $M_{N-1}$,..., M2, M1, tandis que la sortie S1 du module M1 en haut de pile constitue la sortie de données de cette pile, qui sortent donc, comme on le verra ci-après, en série et par ordre décroissant (c'est à dire les plus grands d'abord).

La figure 3 représente le module Mn, n étant un nombre entier compris en 1 et N.

Ce module comporte deux registres, tous deux synchronisés par l'horloge H, dont un premier registre Rmax dont la sortie de données 10 est la sortie Sn du module, et un deuxième registre Rmin dont la sortie de données 11 constitue l'entrée En + 1 du module inférieur Mn + 1 (non représenté) de la pile.

Il est prévu, à l'entrée du module, deux multiplexeurs 19 et 20, qui selon la valeur du niveau continu de commande U/D qu'ils reçoivent sur leur borne de commande 21, 22, commutent sur leur sortie, respectivement 23 et 24, soit leur entrée de droite, respectivement 25 et 26, pour le niveau D, soit leur entrée de gauche, respectivement 27 et 28, pour le niveau U.

Les entrées 25 et 26 reçoivent respectivement l'entrée En provenant du module supérieur et la sortie Sn du registre Rmax, cette dernière étant également appliquée (voir la figure 2) à ce module supérieur.

La sortie 11 du registre Rmin constitue l'entrée En + 1 du module inférieur, et elle constitue l'entrée sur la borne 27 du multiplexeur 19. La borne 28 du multiplexeur 20 reçoit quant à elle la sortie Sn + 1 du module inférieur.

La sortie 23 du multiplexeur 19 est appliquée à la fois à une première entrée 12 d'un comparateur numérique 14 et à une première entrée 13 d'un multiplexeur 15 dont la borne de commande 16 reçoit le signal de sortie du comparateur 14.

L'autre entrée 17 du comparateur 14 ainsi que l'autre entrée 18 du multiplexeur 15 reçoivent le signal de sortie 24 du multiplexeur 26, de sorte que le signal en 16, qui indique quel est le plus grand des deux nombres en 23 et 24, agit sur le multiplexeur 15 pour aiguiller le plus grand de ceux-ci vers le registre Rmax, et le plus petit vers le registre Rmin, tandis que simultanément ce qui se trouvait dans Rmin est transmis en En + 1 vers l'étage inférieur de la pile, soit Mn + 1.

Le fonctionnement de cette pile systolique est le suivant :

En position D, les bornes 26 et 24 d'une part et 25 et 23 d'autre part sont interconnectées de sorte que les sorties 23 et 24 sont respectivement appliquées à 12, 13 et 17, 18.

Au coup d'horloge H, l'entrée En est transmise en Rmax si le contenu Sn de celui-ci lui est inférieur, et alors ce contenu initial de Rmax est transféré en Rmin, tandis que cette entrée En est transmise en Rmin si elle est inférieure au contenu de Rmax. Dans l'un et l'autre cas, le contenu initial de Rmin descend vers l'étage inférieur, qui travaille pour sa part de la même façon et en même temps.

En d'autres termes, la valeur En entrant dans le module Mn est comparée à la valeur Sn stockée dans le registre Rmax de ce module. Le multiplexeur 15 assure l'aiguillage de la donnée, Sn ou En, la plus petite vers le registre Rmin, tandis que la plus grande est mémorisée dans le registre Rmax. La valeur En + 1 sortant du registre Rmin est adressée à l'étage inférieur Mn + 1 où un traitement identique est simultanément effectué.

Une valeur entrant en E1 par le haut de la pile transverse donc, progressivement et au rythme de l'horloge H, les différents étages M1, M2,..., en descendant le long de la pile, jusqu'à son stockage dans le registre Rmax du module qui mémorisait, avant l'entrée de cette valeur, une valeur plus faible que cette dernière. Cette valeur plus faible est, au coup d'horloge suivant, dirigée vers l'étage suivant, selon toujours le même processus : les plus grands nombres restent, tandis que les plus petits descendent, jusqu'à trouver leur place exacte et ordonnée dans la pile.

La pile, formée de la succession des registres Rmax, s'ordonne ainsi automatiquement d'ellemême à chaque coup d'horloge. Lorsqu'une nouvelle donnée E1 est entrée dans cette pile, elle est aussitot comparée à la valeur maximale de la pile, qui se trouve nécessairement en haut de pile. Si elle est plus grande, elle est mémorisée dans le registre Rmax en haut de pile. Sinon, elle aborde l'étage suivant et une nouvelle donnée E1 peut être appliquée à l'entrée 1.

Pour sortir des données de la pile, le niveau de commande est basculé sur U. Les bornes 23 et 24 sont alors respectivement reliées aux bornes 27 et 26.

A chaque coup d'horloge H, le contenu du registre Rmin est alors comparé avec la sortie Sn + 1 du module d'en dessous, et le plus grand de ces deux nombres est placé en Rmax tandis que simultanément le nombre Sn qui était en Rmax est transféré, pour un traitement identique, vers le module du dessus. On remonte ainsi à chaque coup d'horloge le nombre qui est le plus grand des deux nombres du module Mn vers le module supérieur Mn-1. En 8 sort donc à chaque coup d'horloge le plus grand nombre de la pile, de sorte que les données de la pile en sortent bien en série et par ordre décroissant.

Comme il va de soi, l'invention n' est pas limitée à l'exemple de réalisation qui vient d'être décrit, mais elle est au contraire susceptible d'être mise en oeuvre sous bien d'autres formes équivalentes.

## Revendications

1. Procédé de décodage séquentiel d'un train numérique codé par un code correcteur d'erreurs de type convolutif, ce décodage séquentiel utilisant l'algorithme de pile, caractérisé en ce qu'il consiste à utiliser une pile percée en son fond et de taille réduite et à mémoriser le nombre total de noeuds observés, conformément à l'algorithme de pile, lors du décodage d'un bloc, le dépassement par ce nombre d'un valeur limite fixée à l'avance constituant alors l'indication du renoncement au décodage de ce bloc.

2. Procédé de décodage séquentiel selon la revendication 1, caractérisé en ce que, pour éviter la perte du bon chemin sur l'arbre logique du fait que la pile percée conduise à une avalanche d'erreurs, on mémorise en outre la métrique maximale des noeuds abandonnés en fond de pile, et on la compare constamment à la métrique du noeud de plus grande métrique qui se trouve en haut de pile, le résultat de cette comparaison entrainant le renoncement au décodage du bloc lorsque le résultat montre une métrique maximale des noeuds abandonnés en fond de pile qui devient supérieure à celle du haut de pile.

3. Procédé de décodage séquentiel selon la revendication 1 ou la revendication 2, de type selon lequel on mémorise les noeuds examinés, leur profondeur respective et les transitions auxquelles ils correspondent, caractérisé en ce que l'on fixe que les noeuds de numéros pairs correspondent à un premier type de transition, par exemple 0, et que les noeuds de numéros impairs correspondent à l'autre type de transition, par exemple +1, de sorte qu'il n' est alors pas nécessaire de mémoriser la transition correspondant à chaque noeud, puisque cette transition est le LSB du numéro du noeud.

4. Procédé de décodage séquentiel selon l'une des revendications 1 à 3, caractérisé en ce qu'il consiste en outre à mémoriser le chemin exploré de l'arbre logique, de sorte que, lorsque le décodage est terminé du fait qu'on vient d'explorer un noeud situé en bout d'arbre, le bloc décodé est alors directement disponible par cette mémorisation.

5. Dispositif pour la mise en oeuvre du procédé selon l'une des revendications 1 à 4, caractérisé en ce qu'il comporte une pile percée (2) comportant un nombre de modules ne dépassant pas la centaine.

6. Dispositif selon la revendication 5, caractérisé en ce que cette pile (2) comporte environ quarante modules.

7. Dispositif selon la revendication 5 ou la revendication 6, caractérisé en ce qu'il utilise une pile systolique composée d'une cascade de cellules identiques (M1, M2,..., MN) synchronisées par un même signal d'horloge (H), chacune de ces cellules comportant :
   . un premier registre (Rmax) auquel est appilqué ce signal d'horloge (H) ;
   . un deuxième registre (Rmin) auquel est également appliqué ce signal d'horloge ;
   . un comparateur (14) qui peut recevoir d'une part la donnée numérique d'entrée (En) de la cellule, qui provient soit de la cellule supérieure soit, s'il s'agit de la première cellule de la pile, qui est la donnée extérieure entrée dans la pile, et qui peut recevoir d'autre part la donnée (Sn) contenue dans le premier registre (Rmax) ;
   . un multiplexeur (15) qui peut recevoir ces deux données (En, Sn) et qui est commandé par le signal de sortie (16) de ce comparateur (14) de manière à diriger la plus grande des deux (En ou Sn) vers le premier registre (Rmax) pour y remplacer celle (Sn) qui s'y trouve, et à diriger la plus petite des deux vers le deuxième registre (Rmin) pour y remplacer celle (En+1) qui s'y trouve, tandis que cette dernière est tranférée vers l'étage inférieur dont elle constitue la donnée numérique d'entrée ; et deux multiplexeurs (19, 20), commandés par un même signal (U/D) et qui, dans une première position (D) sont aptes à diriger ladite entrée des données (En) et le contenu (Sn) du premier registre (Rmax) vers le comparateur (14), pour stocker et ordonner les données comme précédement, tandis que, dans une seconde position (U), ils sont aptes à diriger vers ce comparateur (14) le contenu (En + 1) du deuxième registre (Rmin) d'un part et le contenu (Sn + 1) du premier registre de la cellule inférieure d'autre part, de sorte qu'ainsi le plus grand nombre (Sn) de la cellule remonte, à chaque coup d'horloge (H), vers la cellule supérieure et que par la suite les données sortent de la pile (en S1) en série et par ordre décroissant.

**FIG 1**

**FIG 2**

**FIG 3**

**Office européen des brevets**

# RAPPORT DE RECHERCHE EUROPEENNE

Numéro de la demande

## EP 91 10 4757

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 797 887   (YAMASAKI et al.) <br> * Colonne 7, ligne 35 - colonne 8, ligne 40 * <br> — — — | 1 | H 03 M 13/12 <br> H 04 L 1/00 |
| A | IEEE TRANSACTIONS ON COMMUNICATIONS, vol. COM-32, no. 2, février 1984, pages 169-176, IEEE, New York, US; J.B. ANDSERON et al.: "Sequential coding algorithms: A survey amd cost analysis" <br> * En entier * <br> — — — | 1 | |
| A | INTERNATIONAL CONFERENCE ON COMMMUNICA-TIONS, Toronto, 4-7 juin 1978, vol. 2, pages 34.1.1 - 34-1.4, IEEE, New York, US; J.B. ANDERSON et al.: "A push-down stack measure of encoding algorithm complexity" <br> * Paragraphe 2 * <br> — — — | 1 | |
| A | IBM J. RES. DEVELOP., vol. 13, no. 6, novembre 1969, pages 675-685; F. JELINEK: "Fast sequential decoding algorithm using a stack" <br> * Pages 681,682, paragraphes 6,7 * <br> — — — — — | 1 | |

|  | DOMAINES TECHNIQUES RECHERCHES (Int. Cl.5) |
|---|---|
| | H 04 L <br> H 03 M <br> G 06 F |

Le présent rapport de recherche a été établi pour toutes les revendications

| Lieu de la recherche | Date d'achèvement de la recherche | Examinateur |
|---|---|---|
| La Haye | 10 juin 91 | BISCHOF J.L.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons
 
& : membre de la même famille, document correspondant